Europäisches Patentamt

European Patent Office

Office européen des brevets

(11) Publication number: **0 222 506**
**A1**

# (12) EUROPEAN PATENT APPLICATION

(21) Application number: 86307814.3

(22) Date of filing: 09.10.86

(51) Int. Cl.4: **H01L 27/10** , G11C 11/24

(30) Priority: 11.10.85 JP 227204/85

(43) Date of publication of application:
20.05.87 Bulletin 87/21

(84) Designated Contracting States:
DE FR GB

(71) Applicant: MITSUBISHI DENKI KABUSHIKI
KAISHA
2-3, Marunouchi 2-chome Chiyoda-ku
Tokyo 100(JP)

(72) Inventor: Mashiko, Koichiro c/o Mitsubishi
Denki
LSI Kenkyusho 1 Mizuhara 4-chome
Itami-shi Hyogo-ken(JP)

(74) Representative: Beresford, Keith Denis Lewis
et al
BERESFORD & Co. 2-5 Warwick Court High
Holborn
London WC1R 5DJ(GB)

(54) Semiconductor memory.

(57) Memory cells (2, 3, 4, 5, 6) are formed on an epitaxial layer (14) using as a starting material a wafer comprising a semiconductor substrate (1) of a first conductivity type and the epitaxial layer (14) of the first conductivity type formed on the semiconductor substrate by epitaxial growth process having a higher impurity concentration than that of the substrate.

FIG.2

## Semiconductor Memory

BACKGROUND OF THE INVENTION

Field of the Invention

The present invention relates to a semiconductor memory, and more particularly relates to an improvement of the structure of a semiconductor memory for storing information in response to the presence or absence of electric charges.

Description of the Prior Art

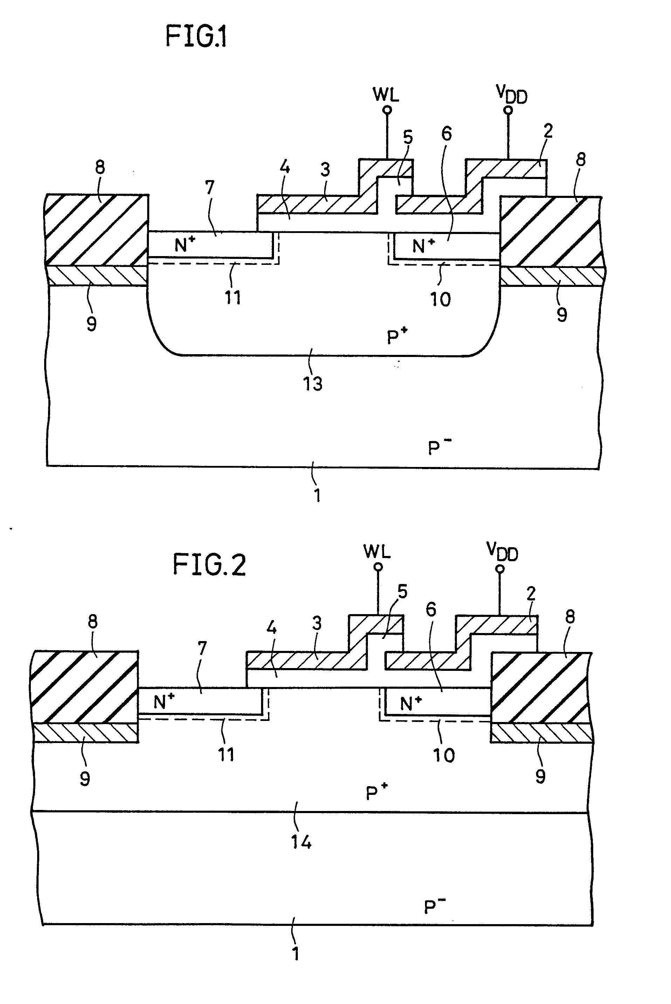

Fig. 1 is a cross sectional view showing a cell structure of a conventional semiconductor memory, which is disclosed in, for example, Japanese Patent Laying-Open Gazette No. 210665/1982. In Fig. 1, a conventional semiconductor memory cell comprises a p type (p$^+$ type) region 13 having a high impurity concentration and formed in a predetermined region on the surface of a p type (p$^-$ type) semiconductor substrate 1 having a low impurity concentration, n$^+$ type impurity diffused layers 6 and 7 formed, respectively, in predetermined regions of the p$^+$ region 13, and a first layer gate electrode 2 and a second layer gate electrode 3 formed, respectively, on the p$^+$ region 13 through a gate insulating film 4. The semiconductor memory cell is electrically isolated from an adjacent cell by a cell isolation region 8 of a thick insulating film and a p$^+$ region 9 formed under the cell isolation region 8.

The first layer gate electrode 2 and the second gate layer electrode 3 form a two-layer structure, and have an overlapping region through an interlayer dielectric film 5. Depletion layers 10 and 11 are formed between the diffused regions 6 and 7 and the p$^+$ region 13, respectively.

In the above described construction, the memory cell comprises a capacitor for storing information in the form of electric charges, and a pass transistor for connecting the capacitor to a bit line in response to signals applied to a word line WL. The pass transistor comprises the n$^+$ impurity diffused region 7 constituting the bit line, and the n$^+$ region 6 to be a charge storage region. The capacitor comprises the first layer gate electrode 2 connected to a power source V$_{DD}$ as one electrode, the n$^+$ region formed under the electrode 2, and the dielectric film between the gate electrode 2 and the n$^+$ region 6. The p$^+$ region 9 under the cell isolation region 8 prevents an inversion layer or a parasitic transistor from being formed therein.

Now, manufacturing process will be described. After the p$^+$ region 9 is formed by selectively implanting and diffusing p type impurities of a high concentration into the predetermined region on the p$^-$ type semiconductor substrate 1, the cell isolation region 8 of the thick insulating film is formed on the p$^+$ region 9 using thermal oxidation process. The p$^+$ region 13 is then formed by implanting and diffusing the p type impurities of a high concentration utilizing the cell isolation region 8 as a mask. The n$^+$ region 6, the first layer gate electrode 2, the n$^+$ region 7, the second layer gate electrode 3 and the like are then formed in accordance with conventional manufacturing process, such as two-layer polysilicon technology. The structure is thus achieved in which both the n$^+$ region 6 and 7 are surrounded by the p$^+$ region 13. The threshold voltage of the pass transistor is generally set to be higher than that of a peripheral transistor in consideration of the stable operation of the memory. The threshold voltage of the pass transistor is defined depending on an impurity concentration in the p$^+$ region 13. If the threshold voltage of the pass transistor fabricated on by the p$^+$ region 13 is too high, it can be controlled to a desired value by dosing n type impurities into a channel region after forming the n$^+$ regions 6 and 7 (prior to forming the gate electrode).

Hence, in Fig. 1, wiring portions and protective films are omitted. For simplicity, it was described that the charge storage region comprises the n$^+$ diffused layer 6. However, in general construction, a structure is adapted such that an n$^+$ type inversion layer is induced in the portion corresponding to the charge storage region 6 on the surface of the semiconductor through the gate insulating film 4 by applying a positive potential V$_{DD}$ to the first layer gate electrode 2, so that charges are stored thereon.

Now, the operation will be described. It is assumed that the state that electrons are stored in the n$^+$ regions 6 corresponds to information "0" and the state that electrons are not stored in the n$^+$ region 6 corresponds to information "1". The n$^+$ region 7 to be a bit line is precharged to a predetermined potential (generally an intermediate potential level). When under such a condition a potential of a word line WL rises and a potential of the second gate electrode 3 connected to the word line WL (functioning as a transfer gate) is made higher than the threshold voltage thereof, an n type inversion layer is formed on the surface of the p$^+$ region immediately under the gate electrode 3, so that conduction between the n$^+$ regions 6 and 7 occurs.

When a selected memory cell has information "0", that is, electrons are stored in the $n^+$ region 6, the conduction between the $n^+$ regions 6 and 7 causes the $n^+$ region 6 to be connected to the bit line, and causes the potential of the $n^+$ region 7 which has been held at a precharge level just before connection of the $n^+$ region 6 to lower. On the other hand, when a memory cell has information "1", that is, electrons are not stored in the $n^+$ region 6, conduction between the $n^+$ regions 6 and 7 occurs the potential of the $n^+$ region 7 which has been precharged at an intermediate potential to rise. The change in potential produced on the bit line is sensed and amplified by the sense amplifier (not shown) for read-out, and the identical stored information is refreshed to be rewritten into the memory cell during the identical cycle.

Recently, with high integration of the semiconductor memory, malfunction referred to as "soft error" occurs remarkably since a 16k DRAM fabrication, where electrons of electron-hole pairs produced by introduction of a radiation ray such as a $\alpha$ ray into a memory chip are collected in the electron storage region and the bit line so that initial stored information is inverted. As described in the foregoing, soft error occurs due to the fact that electrons of the electron-hole pairs produced upon incidence of the radiation ray such as the $\alpha$ ray are collected in the $n^+$ regions 6 and 7 functioning as a charge storage region and a bit line. More particularly, the $\alpha$ ray introduced into the chip produces many electron-hole pairs along the range thereof before the energy thereof is lost and the $\alpha$ ray stops. Of the produced electron-hole pairs, the electron-hole pairs produced in the depletion layers 10 and 11 are immediately separated by an electric field in the depletion layers, so that electrons are collected in the $n^+$ regions 6 and 7, while holes flow out through the substrate 1. The electron-hole pairs produced in the $n^+$ regions 6 and 7 do not contribute to increase and decrease in electrons, since these pairs are recombined therein. In addition, of the electron-hole pairs produced in the substrate 1, only the electrons reaching the depletion layers 10 and 11 by diffusion are collected in the $n^+$ regions 6 and 7, so that soft error occurs, whereas the others are recombined in the substrate 1.

Therefore, in the above described construction, soft error is prevented from occurring by surrounding the respective $n^+$ regions 6 and 7 with the $p^+$ type region 13 having a higher impurity concentration than that of the $p^-$ type substrate 1. More particularly, the width of the depletion layers 10 and 11 formed on the interface between the respective $n^+$ regions 6 and 7 and the $p^+$ region 13 becomes smaller, and junction capacitance of the $n^+$ regions 6 and 7 becomes larger, so that the difference between the number of electrons corresponding to "0" and the number of electrons corresponding to "1" stored in the $n^+$ regions 6 and 7 can be made larger, and margin for electrons produced by incidence of the $\alpha$ ray and the like can be obtained.

Since both the $n^+$ regions 6 and 7 are formed within the $p^+$ region 13, electrons diffused from the $p^-$ type substrate 1 are recombined in the $p^+$ region 13, and do not reach the $n^+$ regions 6 and 7.

In addition, since a potential barrier against electrons is formed on the interface between the $p^-$ type region 1 and the $p^+$ type region 13, of electrons diffused from the $p^-$ type substrate 1, electrons of small energy is not allowed to pass therethrough, so that diffusion of electrons into the $n^+$ regions 6 and 7 is restrained.

As described above, the conventional semiconductor memory is adapted such that soft error is prevented from occurring by forming the $p^+$ type region having a higher impurity concentration than that of the substrate in a predetermined region on the $p^-$ type substrate, and building in the memory cell within the $p^+$ region.

However, there are some problems. For example, it requires a long time to form the $p^+$ region which is essential in the above described construction, so that manufacturing process time becomes longer, and it is difficult to control an impurity concentration of the $p^+$ region, so that the threshold voltage of the pass transistor and the junction breakdown voltage are liable to fluctuate.

The semiconductor memory in which a $p^-$ epitaxial layer having a low impurity concentration is formed on the $p^+$ type substrate and the memory cell is formed on the epitaxial layer so that substrate noise can be reduced is disclosed in an article by L. White et al., entitled "Wide-word 64k bit RAM expands system performance", Electronic Design, March 18, 1982, pp. 231-238. However, the conventional semiconductor memory has no potential barrier layer against electrons between the substrate and the epitaxial layer, because it has a structure of a $p^-$ epitaxial layer on $p^+$ substrate.

## SUMMARY OF THE INVENTION

An object of the present invention is to remove disadvantages of the above described conventional semiconductor memory, and to provide a semiconductor memory capable of shortening the time required for manufacturing process, and easily controlling an impurity concentration of a layer of a conductivity type identical to that of a semiconductor substrate and having a higher impurity concentration than that of the substrate, and thereby easily controlling the threshold voltage and the junction breakdown voltage of a pass transistor.

In accordance with the semiconductor memory of the present invention, a starting material comprises a wafer including a semiconductor substrate of a first conductivity type and an epitaxial layer of the first conductivity type formed on the semiconductor substrate by epitaxial growth process and having a higher impurity concentration than that of the substrate, and a pass transistor and a charge storage region are formed on the epitaxial layer.

The epitaxial layer having a high impurity concentration according to the present invention increases junction capacitance of an impurity diffused region by narrowing a depletion layer between the impurity diffused region to be a bit line and a charge storage region and the epitaxial layer, forms a potential barrier against electrons injected from a $p^-$ type semiconductor substrate, and provides many recombination centers for the injected electrons, so that occurrence of soft error can be prevented.

The epitaxial layer allows manufacturing process to be simplified, and the threshold voltage and the junction breakdown voltage to be easily controlled since the impurity concentration thereof can be easily controlled.

These objects and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a cross sectional view showing a cell structure of a conventional semiconductor memory; and

Fig. 2 is a cross sectional view showing a cell structure of a semiconductor memory of an embodiment of the present invention.

DESCRIPTION OF THE PREFERRED EMBODIMENTS

Fig. 2 is a cross sectional view showing a cell structure of a semiconductor memory of an embodiment of the present invention. In Fig. 2, portions identical and corresponding to a semiconductor memory cell in Fig. 1 have the identical reference numerals.

Referring to Fig. 2, the semiconductor memory according to the present invention is formed using as a starting material a semiconductor wafer comprising a $p^-$ type semiconductor substrate 1 and a $p^+$ type epitaxial layer 14 formed on the $p^-$ type semiconductor substrate 1 by epitaxial growth process. The $p^+$ type epitaxial layer 14 has a higher impurity concentration than that of the $p^-$ type semiconductor substrate 1. An $n^+$ diffused layers 6 and 7, the gate electrodes 2 and 3 and the like are formed within the epitaxial layer 14 through process similar to that of a conventional device.

An impurity concentration of the $p^+$ type epitaxial layer 14 can be easily controlled, so that the desired impurity concentration can be achieved. Therefore, the width of depletion layers 10 and 11 between the $n^+$ regions 6 and 7 and the epitaxial layer 14 can be widely controlled, and electron-hole pairs induced by $\alpha$ rays the depletion layers 10 and 11 can be reduced so that soft error can not adversely effect practical use of the device. However, the $p^+$ type epitaxial layer 14 forms a potential barrier against injection of electrons between the layer 14 and the $p^-$ type substrate 1, and serves as a life time killer due to rich recombination centers thereof, which are similar to the structure of a conventional memory.

Since the $p^+$ epitaxial wafer is utilized as a starting material, impurity injection/diffusion processes required to form a $p^+$ layer (13) shown in Fig. 1 becomes unnecessary and at the same time, a $p^+$ layer having a high impurity concentration can be easily formed, so that soft error due to $\alpha$ rays can be easily controlled, and the requirement for an impurity concentration of a $p^+$ region 9 for preventing occurrence of inversion layers and parasitic transistors under a cell isolation insulating film 8 is relaxed.

It has been found from an experiment that an impurity concentration of the $p^-$ layer 1 of about $10^{15} cm^{-3}$, an impurity concentration of the epitaxial layer 14 of about $10^{16}$ to $10^{18} cm^{-3}$, and a concentration of the $n^+$ layers 6 and 7 of about $10^{18}$ to $10^{20} cm^{-3}$ have a sufficiently improved effect over soft error and at the same time, have a sufficient junction breakdown voltage.

The threshold voltage of a pass transistor controlled for conduction by a word line can be reduced to an optimum value by counter dosing n type impurities under the gate electrode 3.

In addition, the $n^+$ layer 6 in a charge storage region can be formed by counter dosing under the gate electrode 2.

The epitaxial $p^+$ layer 14 may be selectively grown not on the entire wafer but only on an array portion of the memory device.

The present invention applied to a dynamic type memory in the above described embodiment, but it is also applicable to a static type memory.

Furthermore, the present invention is applicable to a memory in which a p conductivity type is replaced with an n conductivity type.

According to the present invention as described above, a wafer is prepared in which a layer of a first conductivity type having a higher impurity concentration than that of a semiconductor substrate of the first conductivity type is epitaxially grown on the substrate, and a memory cell is formed on the epitaxial layer thereof. Therefore, manufacturing process can be simplified and an impurity concentration of the layer of the first conductivity type having a high impurity concentration can be widely controlled, so that a semiconductor memory capable of reducing the generation rate of soft error due to $\alpha$ rays is obtained.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A semiconductor memory comprising:
a semiconductor substrate (1) of a first conductivity type having a first impurity concentration;
an epitaxial layer (14) of the first conductivity type having a second impurity concentration which is higher than said first impurity concentration, and formed on said semiconductor substrate (1) by epitaxial growth process; and
a memory cell formed on said epitaxial layer (14).

2. A semiconductor memory in accordance with claim 1, wherein said memory cell comprising:
capacitor portions (2, 6) formed on a first predetermined region on said epitaxial layer for storing electric charges, and
a pass transistor responsive to signals applied to the gate (3) for connecting said capacitor portions to a bit line through one conductive region (6) and the other conductive region (7) thereof, said one conductive region and the other conductive region comprising an impurity diffused region of a second conductivity type formed in a second predetermined region on said epitaxial layer.

3. A semiconductor memory in accordance with claim 1, wherein said first impurity concentration is $10^{15}$cm$^{-3}$ and said second impurity concentration is $10^{16}$ to $10^{18}$cm$^{-3}$.

4. A semiconductor memory in accordance with claim 2, wherein said second impurity concentration is $10^{16}$ to $10^{18}$cm$^{-3}$ and an impurity concentration in said impurity diffused region of said second conductivity type is $10^{18}$ to $10^{20}$ cm$^{-3}$

5.. A semiconductor memory in accordance with claim 2, wherein the threshold voltage of said pass transistor is controlled by counter dosing impurities of the second conductivity type into the epitaxial layer between said one and the other conductive regions.

6. A semiconductor memory in accordance with claim 2, wherein said capacitor portions have a charge storage region thereof formed by counter dosing impurities of the second conductivity type into the surface of said epitaxial layer.

7. A semiconductor memory in accordance with claim 1, wherein said memory cell is a static type memory cell.

8. A method of making a semiconductor memory comprising the steps of:
providing a semiconductor wafer comprising a substrate (1) of first conductivity type (p$^-$) having a first impurity concentration and an epitaxial layer (14) of second conductivity type having a second impurity concentration (p$^+$) higher than the first concentration, and forming a memory cell (2-11) on the epitaxial layer.

# FIG.1

# FIG.2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IBM TECHNICAL DISCLOSURE BULLETIN, vol. 26, no. 3A, August 1983, pages 940-941, New York, US; G.A: SAI-HALASZ et al.: "Bipolar dynamic RAM cell structure with low soft-error rate" * Figure 2; page 941, paragraph 1 * | 1,3 | H 01 L 27/10 G 11 C 11/24 |
| | --- | | |
| A,D | PATENTS ABSTRACTS OF JAPAN, vol. 7, no. 65 (E-165)[1210], 18th March 1983; & JP-A-57 210 665 (MITSUBISHI DENKI K.K.) 24-12-1982 * Figure 3; abstract * | 1,2,6 | |
| | --- | | |
| A | GB-A-2 114 814 (WESTERN ELECTRIC COMPANY) * Figure 3; page 2, lines 38-48, page 3, lines 54-65 * | 1-6 | TECHNICAL FIELDS SEARCHED (Int. Cl.4) H 01 L G 11 C |
| | --- | | |
| A | PATENTS ABSTRACTS OF JAPAN, vol. 7, no 40 (E-159)[1185], 17th February 1983; & JP-A-57 192 070 (HITACHI SEISAKUSHO K.K.) 26-11-1982 * Figure 2; abstract * | 1,2 | |
| | ---                          -/- | | |

The present search report has been drawn up for all claims

| Place of search | Date of completion of the search | Examiner |
|---|---|---|
| THE HAGUE | 05-01-1987 | CARDON A. |

EPO Form 1503 03 82

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| A | PATENTS ABSTRACTS OF JAPAN, vol. 8, no. 198 (E-265)[1635], 11th September 1984; & JP-A-59 84 461 (HITACHI SEISAKUSHO K.K.) 16-05-1984 * Figure; abstract * | 1,7 | |

-----

TECHNICAL FIELDS
SEARCHED (Int. Cl.4)

The present search report has been drawn up for all claims

| Place of search | Date of completion of the search | Examiner |
|---|---|---|
| THE HAGUE | 05-01-1987 | CARDON A. |